(19) Europäisches Patentamt
European Patent Office
Office européen des brevets

(11) **EP 2 567 418 B1**

(12) **FASCICULE DE BREVET EUROPEEN**

(45) Date de publication et mention
de la délivrance du brevet:
**20.08.2014 Bulletin 2014/34**

(21) Numéro de dépôt: **11718975.3**

(22) Date de dépôt: **03.05.2011**

(51) Int Cl.:
*H01L 51/00* (2006.01)     *H01L 51/05* (2006.01)
*H01L 27/28* (2006.01)

(86) Numéro de dépôt international:
**PCT/EP2011/057065**

(87) Numéro de publication internationale:
**WO 2011/138332 (10.11.2011 Gazette 2011/45)**

(54) **DISPOSITIF MICROELECTRONIQUE A PORTIONS DISJOINTES DE SEMI-CONDUCTEUR ET PROCEDE DE REALISATION D'UN TEL DISPOSITIF**

MIKROELEKTRONISCHE VORRICHTUNG MIT GETRENNTEN HALBLEITERTEILEN UND VERFAHREN ZUR HERSTELLUNG EINER DERARTIGEN VORRICHTUNG

MICROELECTRONIC DEVICE HAVING DISCONNECTED SEMICONDUCTOR PORTIONS AND METHOD FOR PRODUCING SUCH A DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **05.05.2010 FR 1053508**

(43) Date de publication de la demande:
**13.03.2013 Bulletin 2013/11**

(73) Titulaire: **Commissariat à l'Énergie Atomique et aux Énergies Alternatives
75015 Paris (FR)**

(72) Inventeurs:
• **GWOZIECKI, Romain**
**F-52800 Foulain (FR)**
• **COPPARD, Romain**
**F-38500 Voiron (FR)**

(74) Mandataire: **Ilgart, Jean-Christophe
BREVALEX
95, rue d'Amsterdam
75378 Paris Cedex 8 (FR)**

(56) Documents cités:
**EP-A1- 1 727 219     EP-A1- 2 113 944
US-A1- 2007 120 167     US-A1- 2007 132 023**

• **VERILHAC J M ET AL: "Step toward robust and reliable amorphous polymer field-effect transistors and logic functions made by the use of roll to roll compatible printing processes", ORGANIC ELECTRONICS, ELSEVIER, AMSTERDAM, NL, vol. 11, no. 3, 1 mars 2010 (2010-03-01), pages 456-462, XP026888758, ISSN: 1566-1199, DOI: DOI:10.1016/J.ORGEL. 2009.11.027 [extrait le 2009-11-26]**

**Description**

## DOMAINE TECHNIQUE

L'invention concerne un dispositif microélectronique comportant des portions disjointes de semi-conducteur, et plus particulièrement un dispositif microélectronique comportant un ou plusieurs transistors formés à partir de telles portions disjointes de semi-conducteur en tant que zones actives.

L'invention est particulièrement adaptée au domaine des transistors à film mince (TFT), et notamment celui des transistors à film mince organique (OFET ou OTFT).

## ÉTAT DE LA TECHNIQUE ANTÉRIEURE

La réalisation d'un dispositif à film mince, tel qu'un transistor à film mince, comportant une couche mince de semi-conducteur par exemple à base d'un matériau organique, implique une mise en forme de cette couche de semi-conducteur afin de réaliser ensuite les électrodes qui formeront des contacts électriques de source et de drain, mais également pour que le transistor obtenu présente un faible courant $I_{off}$ (correspondant au courant $I_{DS}$ pour $V_{GS} = 0$ et $V_{DS} = V_{alim}$) et des capacités parasites les plus faibles possible.

Pour pouvoir mettre en forme la couche de semi-conducteur, l'équipement utilisé pour déposer la couche de semi-conducteur doit donc disposer d'un système d'alignement. Ce type d'équipement à alignement dérive des équipements d'impression traditionnels, comme par exemple des machines d'impression en rouleau (« roll-to-roll processing » en anglais), dont les performances, en termes de précision d'alignement, sont généralement mauvaises.

En raison de ces imprécisions d'alignement, ces transistors à film mince sont dimensionnés avec des marges (sur les dimensions) supérieures aux tolérances minimales d'alignement des équipements, ce qui limite fortement la densité d'intégration de ces transistors pouvant être obtenue.

EP 1727 219 A1 décrit un dispositif microélectronique comportant des portions disjointes de semi-conducteur.

## EXPOSÉ DE L'INVENTION

Un but de la présente invention est de proposer un nouveau dispositif semi-conducteur, ainsi qu'un nouveau procédé de réalisation de dispositif semi-conducteur, dont la structure permette de s'affranchir des étapes d'alignement devant être mises en oeuvre au cours de la réalisation des dispositifs semi-conducteurs à film mince de l'art antérieur.

Pour cela, la présente invention propose un dispositif microélectronique comportant :

- une pluralité de portions de semi-conducteur disjointes de dimensions $L_{SC}$, $W_{SC}$ et de formes sensiblement similaires, isolées électriquement les unes des autres et formant une couche de semi-conducteur, chacune des portions de semi-conducteur étant espacée des portions de semi-conducteur adjacentes d'une distance $E_{SCH}$, $E_{SCV}$ sensiblement constante et comportant une forme allongée dont une plus grande dimension $L_{SC}$ est orientée sensiblement parallèlement aux plus grandes dimensions $L_{SC}$ des autres portions de semi-conducteur,

- au moins deux électrodes disposées en contact avec la couche de semi-conducteur telles qu'une distance $L_{canal}$ maximale séparant les deux électrodes soit inférieure à une plus grande dimension $L_{SC}$ d'une des portions de semi-conducteur, dans lequel la forme et les dimensions $L_{SC}$, $W_{SC}$ des portions de semi-conducteur, l'espacement $E_{SCH}$, $E_{SCV}$ entre les portions de semi-conducteur, la forme et les dimensions $L_{SD}$, $W_{SD}$ des électrodes ainsi que la disposition des électrodes par rapport aux portions de semi-conducteur sont tels qu'au moins une des portions de semi-conducteur relie électriquement les deux électrodes entre elles,

les plus grandes dimensions $L_{SC}$ des portions de semi-conducteur sont sensiblement perpendiculaires à une plus grande dimension $W_{SD}$ des électrodes, les électrodes étant de formes et de dimensions $W_{SD}$, $L_{SD}$ sensiblement similaires,

les portions de semi-conducteur sont disposées, dans un plan parallèle à une face principale de la couche de semi-conducteur au contact de laquelle sont disposées les électrodes, conformément à un motif régulier de lignes parallèles,

des espaces $E_{SCH}$ entre les portions de semi-conducteur d'une même ligne sont décalés, par rapport à des espaces entres les portions de semi-conducteur d'une ligne adjacente et selon une direction parallèle aux lignes, d'une distance D égale à environ la plus grande dimension $L_{SC}$ des portions de semi-conducteur divisée par n, avec n nombre réel compris entre 10 et 20,

et dans lequel la plus grande dimension $L_{SC}$ des portions de semi-conducteur est sensiblement égale à n fois la distance $L_{canal}$ maximale séparant les deux électrodes et/ou dans lequel la plus grande dimension $W_{SD}$ des électrodes est supérieure à environ n fois la plus petite dimension $W_{SC}$ des portions de semi-conducteur.

On propose donc de réaliser la couche de semi-conducteur d'un dispositif microélectronique sous la forme d'un ensemble de petites portions de semi-conducteur réparties par exemple de façon homogène, dimensionnées et espacées telles que statistiquement on obtienne, en disposant au moins deux électrodes du dispositif contre ces portions de semi-conducteur sans alignement particulier par rapport à ces portions de semi-conducteur, au moins une surface de semi-conducteur, par exemple destinée à former une ou plusieurs zones actives du dispositif, qui soit « auto-alignée » par rapport aux électrodes, c'est-à-dire ici apte à réaliser une conduction électrique entre les deux électrodes. Ainsi, un tel dispositif peut être réalisé tel qu'au moins une des portions de semi-conducteur soit apte à assurer une conduction électrique entre les deux électrodes sans avoir à se préoccuper de l'alignement des électrodes vis-à-vis des portions de semi-conducteur.

De plus, une telle couche de semi-conducteur permet de réaliser plusieurs dispositifs semi-conducteur, par exemple des transistors, les uns à côté des autres qui seront automatiquement isolés électriquement les uns des autres en choisissant un espacement minimal adéquat entre les électrodes des dispositifs étant donné que les portions de semi-conducteur sont initialement isolées électriquement les unes des autres, seules les électrodes de chaque dispositif étant reliées électriquement entre elles par une ou plusieurs des portions de semi-conducteur.

La couche de semi-conducteur peut être avantageusement une couche mince, c'est-à-dire une couche d'épaisseur inférieure ou égale à environ 100 nm lorsque le semi-conducteur est un matériau organique ou inférieure ou égale à environ 100 nm ou quelques dizaines de nanomètres, par exemple environ 50 nm, lorsque le semi-conducteur est un matériau inorganique.

Le dispositif tel que défini dans la revendication 1 a également pour avantage de présenter une faible dispersion sur les caractéristiques électriques du dispositif du fait que la dispersion concernant le nombre de portions de semi-conducteur reliant électriquement les deux électrodes est également faible.

Chacune des portions de semi-conducteur comporte une forme allongée, ou oblongue, dont une plus grande dimension $L_{SC}$ est orientée sensiblement parallèlement aux plus grandes dimensions $L_{SC}$ des autres portions de semi-conducteur.

Selon un mode de réalisation avantageux, chacune des portions de semi-conducteur peut comporter une forme sensiblement rectangulaire.

Les portions de semi-conducteur peuvent être disposées, dans un plan parallèle à une face principale de la couche de semi-conducteur au contact de laquelle sont disposées les électrodes, conformément à un motif régulier de lignes parallèles. Un tel motif a notamment pour avantage d'être facilement réalisable en raison de la répétitivité du motif qui peut être formé de plusieurs lignes de portions de semi-conducteur, ce motif étant répété une ou plusieurs fois.

Des espaces $E_{SCH}$ entre les portions de semi-conducteur d'une même ligne sont décalés, par rapport à des espaces entres les portions de semi-conducteur d'une ligne adjacente et selon une direction parallèle aux lignes, d'une distance D égale à environ la plus grande dimension $L_{SC}$ des portions de semi-conducteur divisée par n, avec n nombre réel compris entre 10 et 20. Ainsi, on obtient un décalage ligne à ligne des portions de semi-conducteur, formant un motif de répétition régulier desdites lignes.

Dans ce cas, la plus grande dimension $L_{SC}$ des portions de semi-conducteur peut être sensiblement égale à n fois la distance maximale $L_{canal}$ séparant les deux électrodes et/ou la plus grande dimension $W_{SD}$ des électrodes peut être supérieure à environ n fois la plus petite dimension $W_{SC}$ des portions de semi-conducteur.

Les plus grandes dimensions $L_{SC}$ des portions de semi-conducteur sont sensiblement perpendiculaires à une plus grande dimension $W_{SD}$ des électrodes, les électrodes étant de formes et de dimensions $W_{SD}$, $L_{SD}$ sensiblement similaires.

Le dispositif peut comporter au moins un transistor dont une zone active peut être formée par ladite au moins une des portions de semi-conducteur reliant électriquement les deux électrodes entre elles, lesdites électrodes formant des électrodes de source et de drain du transistor.

Le dispositif peut comporter une pluralité de transistors, chaque transistor pouvant comporter :

- au moins deux électrodes formant des électrodes de source et de drain disposées en contact avec la couche de semi-conducteur telles qu'une distance $L_{canal}$ maximale séparant les deux électrodes d'un des transistors soit inférieure à environ la plus grande dimension $L_{SC}$ d'une des portions de semi-conducteur,
- une zone active formée par au moins une des portions de semi-conducteur reliant électriquement les deux électrodes dudit transistor entre elles,

et dans lequel,

- les plus grandes dimensions $L_{SC}$ des portions de semi-conducteur peuvent être sensiblement perpendiculaires à une plus grande dimension $W_{SD}$ des électrodes, les électrodes pouvant être de formes et de dimensions $W_{SD}$, $L_{SD}$ sensiblement similaires,
- une distance $E_{TR}$ séparant les électrodes de deux transistors, selon une direction parallèle à la plus grande dimension des portions de semi-conducteur, pouvant être supérieure à environ la plus grande dimension des portions de semi-conducteur, et
- les électrodes de deux transistors pouvant être décalées, selon une direction sensiblement parallèle à la plus grande dimension $W_{SD}$ des électrodes, d'une distance $E_{CO}$ supérieure à environ la plus petite dimension $W_{SC}$ des portions de semi-conducteur.

Le ou chaque transistor peut comporter en outre un diélectrique de grille et une grille disposés en regard de la zone active dudit transistor.

Les portions de semi-conducteur peuvent être à base d'au moins un semi-conducteur organique.

L'invention concerne en outre un procédé de réalisation d'un dispositif microélectronique comportant au moins les étapes de :

- réalisation d'une pluralité de portions de semi-conducteur disjointes de dimensions $L_{SC}$, $W_{SC}$ et de formes sensiblement similaires, isolées électriquement les unes des autres et formant une couche de semi-conducteur, chacune des portions de semi-conducteur étant espacée des portions de semi-conducteur adjacentes d'une distance $E_{SCH}$, $E_{SCV}$ sensiblement constante et comporte une forme allongée dont une plus grande dimension $L_{SC}$ est orientée sensiblement parallèlement aux plus grandes dimensions $L_{SC}$ des autres portions de semi-conducteur,
- réalisation d'au moins deux électrodes disposées en contact avec la couche de semi-conducteur telles qu'une distance $L_{canal}$ maximale séparant les deux électrodes soit inférieure à environ une plus grande dimension $L_{SC}$ d'une des portions de semi-conducteur,

dans lequel la forme et les dimensions $L_{SC}$, $W_{SC}$ des portions de semi-conducteur, l'espacement $E_{SCH}$, $E_{SCV}$ entre les portions de semi-conducteur, la forme et les dimensions $L_{SD}$, $W_{SD}$ des électrodes ainsi que la disposition des électrodes par rapport aux portions de semi-conducteur étant tels qu'au moins une des portions de semi-conducteur relie électriquement les deux électrodes entre elles,

les plus grandes dimensions Lsc des portions de semi-conducteur sont sensiblement perpendiculaires à une plus grande dimension $W_{SD}$ des électrodes, les électrodes étant de formes et de dimensions $W_{SD}$, $L_{SD}$ sensiblement similaires,

les portions de semi-conducteur sont disposées, dans un plan parallèle à une face principale de la couche de semi-conducteur au contact de laquelle sont disposées les électrodes, conformément à un motif régulier de lignes parallèles,

des espaces $E_{SCH}$ entre les portions de semi-conducteur d'une même ligne sont décalés, par rapport à des espaces entres les portions de semi-conducteur d'une ligne adjacente et selon une direction parallèle aux lignes, d'une distance D égale à environ la plus grande dimension $L_{SC}$ des portions de semi-conducteur divisée par n, avec n nombre réel compris entre 10 et 20,

et dans lequel la plus grande dimension $L_{SC}$ des portions de semi-conducteur est sensiblement égale à n fois la distance $L_{canal}$ maximale séparant les deux électrodes et/ou dans lequel la plus grande dimension $W_{SD}$ des électrodes est supérieure à environ n fois la plus petite dimension $W_{SC}$ des portions de semi-conducteur.

Les portions de semi-conducteur peuvent être réalisées en mettant en oeuvre une étape de dépôt du semi-conducteur de type sérigraphie, impression par tampon ou héliographie, ou en mettant en oeuvre une étape de dépôt d'une couche dudit semi-conducteur puis une étape d'ablation par laser ou par photolithogravure ou par emboutissage de la couche de semi-conducteur.

Les portions de semi-conducteur peuvent être tout d'abord réalisées sur un substrat, les électrodes pouvant être ensuite réalisées sur les portions de semi-conducteur. Dans une variante, les électrodes peuvent être tout d'abord réalisées sur un substrat, les portions de semi-conducteur pouvant être ensuite réalisées sur les électrodes.

**BRÈVE DESCRIPTION DES DESSINS**

La présente invention sera mieux comprise à la lecture de la description d'exemples de réalisation donnés à titre purement indicatif et nullement limitatif en faisant référence aux dessins annexés sur lesquels :

- les figures 1 à 3 sont des vues de dessus schématiques d'une partie des éléments d'un dispositif microélectronique, objet de la présente invention, selon un mode de réalisation particulier,
- les figures 4 et 5 sont des vues en coupe schématiques d'un dispositif microélectronique, objet de la présente invention, selon deux exemples de réalisation particuliers.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

**EXPOSÉ DÉTAILLÉ DE MODES DE RÉALISATION PARTICULIERS**

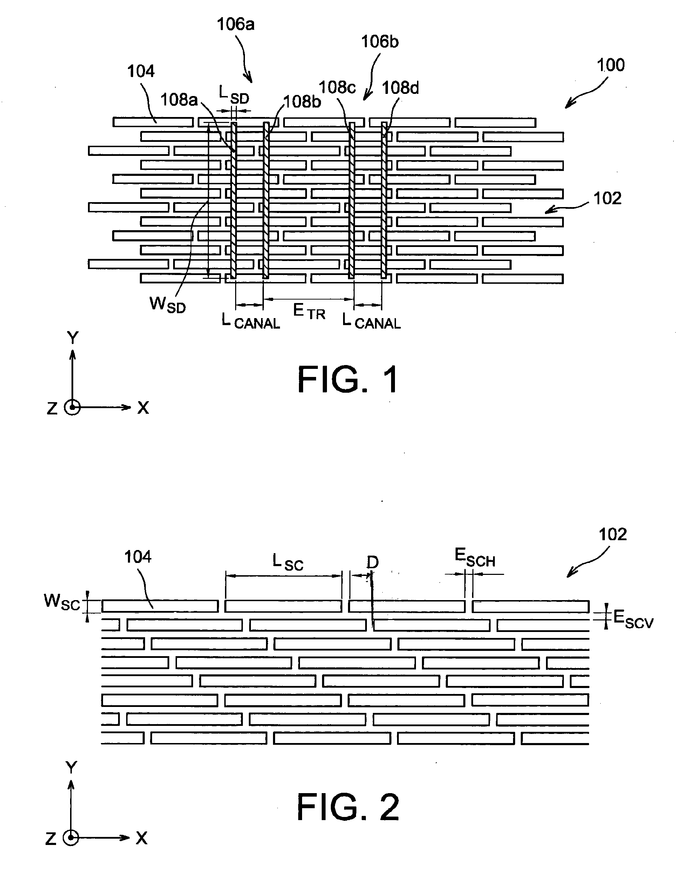

On se réfère tout d'abord à la figure 1 qui représente schématiquement et partiellement un dispositif microélectronique 100 comportant une couche de semi-conducteur 102 formée par une pluralité de portions disjointes de semi-conducteur 104.

Ces portions disjointes de semi-conducteur 104 ont toutes, sur l'exemple de la figure 1, une forme rectangulaire et des dimensions sensiblement similaires d'une portion à l'autre. Etant donné que les portions 104 sont disjointes, c'est-à-dire non en contact les unes avec les autres, elles sont isolées électriquement les unes des autres.

On voit sur la figure 1 que les portions de semi-conducteur 104 forment, dans le plan (X,Y), un motif régulier discrétisé de rectangles, formant des lignes parallèles les unes aux autres de portions de semi-conducteur 104. De plus, les espaces séparant les portions de semi-conducteur 104 sont de dimensions sensiblement constantes entre toutes les portions de semi-conducteur 104. En variante, les portions de semi-conducteur 104 peuvent avoir une forme autre qu'une forme rectangulaire, tout en étant répartis régulièrement.

D'une ligne à l'autre, les portions de semi-conducteur 104 ne sont pas alignées verticalement (selon l'axe y) les unes au-dessus des autres. En effet, d'une ligne à l'autre, les portions de semi-conducteur 104 sont décalées horizontalement (selon l'axe x). De plus, il existe une régularité dans ce décalage horizontal. Le motif formé par les portions 104 est composé de plusieurs groupes similaires de lignes de portions de semi-conducteur disposés les uns au-dessus des autres. Ainsi, sur l'exemple de la figure 1, on voit que le motif formé par l'ensemble des portions de semi-conducteur 104 est constitué par des groupes similaires de quatre lignes disposés les uns au-dessus des autres. En d'autres termes, les portions de semi-conducteur 104 d'une des lignes sont alignées verticalement (selon l'axe Y) avec les portions de semi-conducteur 104 de la 4ème ligne inférieure et de la 4ème ligne supérieure par rapport à ladite ligne.

Un autre exemple de motif formé par les portions de semi-conducteur 104 de la couche 102 est représenté sur la figure 2. Sur cet exemple, on voit que d'une ligne à l'autre, les portions de semi-conducteur 104 sont décalées horizontalement d'une distance D. De plus, sur cet exemple, les portions de semi-conducteur 104 d'une ligne sont alignées verticalement (selon l'axe Y) avec les portions de semi-conducteur 104 se trouvant cinq lignes au-dessus ou en-dessous de cette ligne.

Etant donné que ce décalage D est identique d'une ligne à l'autre, on a donc :

$$L_{SC} + E_{SCH} = n * D$$

avec $L_{SC}$ : longueur (ou plus généralement la plus grande dimension) d'une portion de semi-conducteur 104,

$E_{SCH}$ : espacement horizontal entre deux portions de semi-conducteur 104, c'est-à-dire la distance séparant deux portions de semi-conducteur 104 adjacentes d'une même ligne,

n : nombre de portions de semi-conducteur 104 pour former le pas de répétition, supérieur à 1.

Sur l'exemple de la figure 2, on a n = 5 car l'alignement initial d'une ligne de portions de semi-conducteur 104 se retrouve cinq lignes plus loin.

L'espacement entre deux lignes de portions de semi-conducteur 104, noté $E_{SCV}$ sur l'exemple de la figure 2, peut être sensiblement similaire à l'espacement horizontal entre deux portions de semi-conducteur 104, tel que $Escv = E_{SCH}$.

Bien que sur les exemples des figures 1 et 2 les portions de semi-conducteur 104 aient chacune une forme rectangulaire, ces portions peuvent avoir une forme différente, mais avantageusement une forme oblongue ou allongée.

Une partie des portions de semi-conducteur disjointes 104 est destinée à formée la ou les zones actives du dispositif microélectronique 100, et à être en contact avec des électrodes du dispositif microélectronique 100.

Sur l'exemple de la figure 1, le dispositif microélectronique 100 comporte deux transistors 106a, 106b comportant chacun deux électrodes, respectivement référencées 108a, 108b et 108c, 108d. Ces électrodes 108a-108d correspondent aux électrodes de source et de drain des transistors 106a, 106b et sont disposées contre la couche de semi-conducteur 102 formée par les portions de semi-conducteur 104. Chacune de ces électrodes 108a-108d a une forme sensiblement rectangulaire dont la longueur (la plus grande dimension) est disposée sensiblement perpendiculairement à la longueur des portions de semi-conducteur 104.

De plus, les deux électrodes 108a, 108b et 108c, 108d de chaque transistor 106a, 106b sont espacées l'une de l'autre d'une distance $L_{canal}$, qui correspond à la longueur du canal du transistor, qui est inférieure à $L_{SC}$. Ainsi, les portions de semi-conducteur 104 qui sont en contact avec les deux électrodes 108a, 108b, ou 108c, 108d d'un des transistors 106a, 106b sont donc aptes à former un chemin de conduction électrique entre ces deux électrodes. Ces portions de semi-conducteur 104 forment donc la zone active (source + drain + canal) du transistor. Sur l'exemple de la figure 1, on voit que chacune des zones actives des transistors 106a et 106b est formée par neuf portions de semi-conducteur 104 qui sont en contact avec les deux électrodes 108a, 108b ou 108c, 108d du transistor en question.

Etant donné que les portions de semi-conducteur 104 et les électrodes 108a-108d sont dimensionnées telles que $L_{canal} < L_{SC}$, et que les électrodes 108a-108d sont positionnées telles que la longueur de chaque électrode 108a-108d soit sensiblement perpendiculaire à la longueur des portions de semi-conducteur 104, il est donc possible de réaliser les électrodes 108a-108d n'importe où sur la couche 102 formée par les portions de semi-conducteur 104 sans procéder à un alignement préalablement des électrodes 108a-108d vis-à-vis de la couche de semi-conducteur 102 étant donné que, quel que soit l'emplacement des électrodes 108a-108d, une ou plusieurs portions de semi-conducteur 104 sont nécessairement en contact avec les deux électrodes 108a, 108b et 108c, 108d de chaque transistor 106a, 106b et forment les zones actives des transistors 106a, 106b.

Afin d'éviter un court-circuit entre les transistors 106a, 106b, la distance $E_{TR}$ entre les électrodes 108a-108d les plus proches des transistors 106a, 106b (entre les électrodes 108b et 108c sur l'exemple de la figure 1), qui correspond à l'espacement horizontal entre les deux transistors 106a, 106b, est choisie telle qu'elle soit supérieure à la longueur $L_{SC}$ des portions de semi-conducteur 104. Ainsi, en respectant la condition $E_{TR} > L_{SC}$, quel que soit l'emplacement des transistors 106a, 106b sur la couche de semi-conducteur 102, aucune des portions de semi-conducteur 104 ne peut court-circuiter les électrodes les plus proches de chacun des transistors 106a, 106b.

La longueur des électrodes 108a-108d, notée $W_{SD}$, est choisie de préférence telle que $W_{SD} \gg W_{SC}$ ou telle que $W_{SD} > n.W_{SC}$, avec $W_{SC}$ correspondant à la largeur des portions de semi-conducteur 104 ou, plus généralement, à la plus petite dimension des portions 104 étant donné que les portions de semi-conducteur 104 peuvent avoir une forme autre qu'une forme rectangulaire. Etant donné que les électrodes 108a-108d sont réalisées sans alignement vis-à-vis de la couche de semi-conducteur 102, le respect de la condition $W_{SD} \gg W_{SC}$ ou $W_{SD} > n.W_{SC}$ permet d'aboutir à une faible dispersion statistique du nombre de portions de semi-conducteur 104 formant les zones actives des différents transistors réalisés à partir des portions de semi-conducteur 104, et donc une faible dispersion du courant $I_{ON}$ entre ces différents transistors. On voit donc que plus le nombre n du motif formé par les portions de semi-conducteur 104 est grand, plus cette dispersion sera faible.

La densité des transistors pouvant être obtenue est fonction de l'espacement entre deux transistors $E_{TR}$, et donc fonction de la valeur de $L_{SC}$ (car $E_{TR} > L_{SC}$).

Le paramètre n est donc le paramètre qui conditionne le compromis entre la dispersion des caractéristiques des éléments du dispositif microélectronique 100 et la densité de ces éléments.

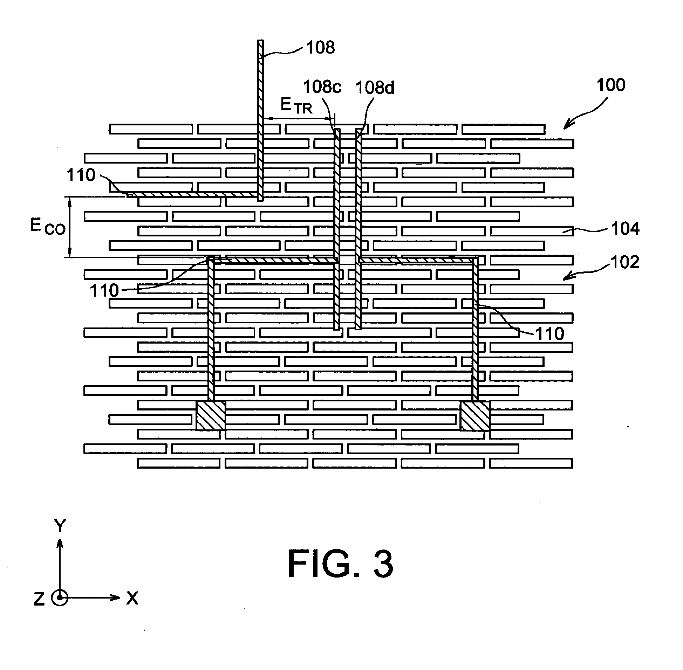

Les transistors 106a, 106b comportent également des lignes de connexion, ou lignes électriques, 110 reliées électriquement aux électrodes 108a-108d et formées sur la couche de semi-conducteur 102. De telles lignes électriques 110 sont par exemple représentées sur la figure 3. Etant donné que ces lignes électriques 110 peuvent s'étendre sur la couche de semi-conducteur 102 telles qu'elles se retrouvent au-dessus ou en-dessous d'autres contacts ou lignes électriques et/ou d'autres électrodes de transistors adjacents, on positionne ces lignes 110 telles qu'une distance $E_{CO}$, correspondant à l'espacement entre deux éléments conducteurs de deux transistors distincts, soit supérieure à $W_{SC}$, c'est-à-dire supérieure à la largeur des portions de semi-conducteur 104. Ainsi, en respectant la condition $E_{CO} > W_{SC}$, on garantit qu'une portion de semi-conducteur 104 qui est en contact avec l'un des deux éléments électriquement conducteur (ligne électrique ou électrode) qui sont disposés l'un au-dessus de l'autre ne le soit pas avec l'autre des deux éléments.

Ainsi, il est possible de réaliser les électrodes 108a-108d sans alignement particulier vis-à-vis de la ou des zones actives du dispositif microélectronique 100.

Dans l'exemple décrit ici, les deux transistors 106a, 106b sont du même type, par exemple tous les deux dopés n ou p. Toutefois, il est également possible que les deux transistors 106a, 106b soient des transistors de types différents, pouvant ainsi former un dispositif CMOS. Un tel dispositif peut être obtenu soit en déposant des zones de semi-conducteur dopées selon des types différents (par exemple n et p), soit en déposant des matériaux d'électrodes différents au sein d'un même transistor ou entre les deux transistors.

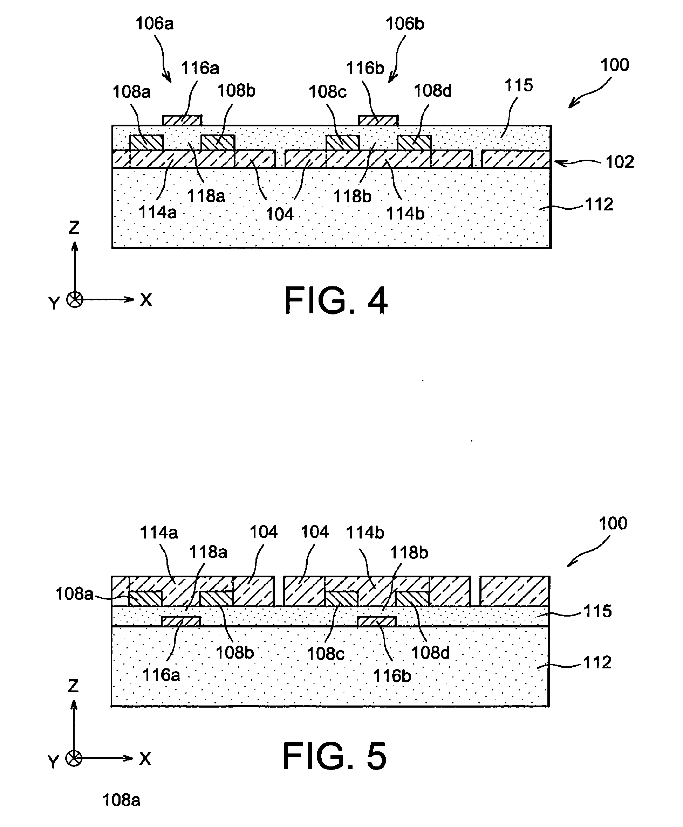

On se réfère maintenant à la figure 4 qui représente une vue en coupe du dispositif microélectronique 100 selon un premier exemple de réalisation.

Le dispositif microélectronique 100 comporte un substrat 112, par exemple à base de verre ou de tout autre matériau isolant ou tout matériau recouvert d'un film isolant, sur lequel sont disposées les portions de semi-conducteur 104 formant la couche de semi-conducteur 102. Les portions de semi-conducteur 104 peuvent être à base de n'importe quel matériau semi-conducteur, tant organique qu'inorganique. Lorsque les portions de semi-conducteur 104 sont à base d'un matériau organique, ce matériau est par exemple du pentacène ou du poly(triarylamine). Lorsque les portions de semi-conducteur 104 sont à base d'un matériau inorganique, ce matériau est par exemple de l'oxyde de zinc (ZnO), du silicium amorphe ou du polysilicium. Les électrodes 108a-108d sont réalisées sur les portions de semi-conducteur 104 et sont à base d'un matériau électriquement conducteur, par exemple un métal tel que de l'or. Les zones 114a, 114b des portions 104, délimitées par des pointillées sur la figure 4, forment les zones actives des transistors 106a, 106b.

Les portions de semi-conducteur 104 et les électrodes 108a-108d sont recouvertes par une couche diélectrique 115, par exemple à base de $SiO_2$, de $Si_3N_4$ ou de polymères isolants tels que du polystyrène ou de polymère fluoré tel que du CYTOP®, sur laquelle sont réalisées des grilles 116a, 116b des transistors 106a, 106b, par exemple à base d'un métal tel que de l'or, de l'argent ou une encre métallique ou de polysilicium. Des portions 118a, 118b de la couche diélectrique 115 se trouvant entre les grilles 116a, 116b et les zones actives 114a, 114b forment les diélectriques de grille des transistors 106a, 106b.

Dans une variante de ce premier exemple de réalisation, il est possible de disposer les électrodes 108a-108d directement contre ou en contact avec le substrat 112, puis de former les portions de semi-conducteur 104 telles qu'elles recouvrent les électrodes 108a-108d. Les portions de semi-conducteur 104 seraient dans ce cas recouvertes par la couche diélectrique 115 sur laquelle les grilles 116a, 116b seraient disposées.

On se réfère maintenant à la figure 5 qui représente une vue en coupe du dispositif microélectronique 100 selon un second exemple de réalisation.

Par rapport au premier exemple de réalisation de la figure 4, les grilles 116a, 116b sont tout d'abord disposées contre le substrat 112. Ces grilles 116a, 116b sont recouvertes par la couche diélectrique 115. Les électrodes 108a-108d sont ensuite réalisées sur la couche diélectrique 115. Enfin, les portions de semi-conducteur 104 sont réalisées sur la couche diélectrique 115 et sur les électrodes 108a-108d.

Dans une variante de ce second exemple de réalisation, il est possible que les portions de semi-conducteur 104 soient disposées contre la couche diélectrique 115 et que les électrodes 108a-108d soient ensuite réalisées sur les portions de semi-conducteur 104.

Dans les exemples précédemment décrits, le dispositif microélectronique 100 comporte plusieurs transistors. Toutefois, il est tout à fait possible que le dispositif semi-conducteur 100 comporte, à la place des transistors, d'autres composants électroniques comportant chacun au moins deux électrodes, par exemple des diodes.

Différentes techniques de réalisation peuvent être mises en oeuvre pour réaliser la couche de semi-conducteur 102 comportant les portions disjointes de semi-conducteur 104. Le choix de la technique à mettre en oeuvre sera notamment fait en fonction des dimensions des portions de semi-conducteur 104.

Ainsi, pour des portions de semi-conducteur 104 de largeur $W_{SC}$ de l'ordre de 1 $\mu$m ou plus généralement inférieure à environ 10 $\mu$m, ces portions 104 pourront être réalisées avantageusement par lithographie Nanoimprint ou par impression par tampon (« Stamping » en anglais), ou encore un dépôt pleine couche de semi-conducteur puis par ablation laser ou par photolithogravure de cette couche. Pour des portions de semi-conducteur 104 de largeur $W_{SC}$ supérieure ou égale à environ 10 $\mu$m, ces portions 104 pourront être réalisées avantageusement par héliographie ou bien par les techniques précédemment citées.

Le nombre n pourra être choisi relativement grand, par exemple de l'ordre de 10, ou compris entre 10 et 20, afin d'avoir une faible dispersion (environ 10 %) sur les caractéristiques électriques des éléments du dispositif semi-conducteur 100. Ainsi, avec un nombre n égal à 10 et une largeur $W_{SC}$ égale à environ 1 $\mu$m, la longueur des électrodes $W_{SD}$ sera choisie supérieure à environ 10 $\mu$m.

La longueur de canal $L_{canal}$ est par exemple égale à environ 5 $\mu$m. Dans ce cas, la longueur $L_{SC}$ des portions 104 est par exemple égale à environ n*$L_{canal}$, c'est-à-dire égale à environ 50 $\mu$m. L'espacement entre les transistors $E_{TR}$ sera donc choisi supérieur à 50 $\mu$m, par exemple égal à environ 60 $\mu$m.

Les dimensions $E_{SCH}$ et $E_{SCV}$ entre les portions de semi-conducteur pourront être choisies les plus petites possibles, à condition que l'isolement électrique entre les portions de semi-conducteur 104 soit bien conservé. Ces dimensions pourront être de l'ordre du micromètre lorsque les portions 104 sont réalisées par héliographie, ou de l'ordre d'environ 100 nm lorsque les portions 104 sont réalisées par emboutissage, ou de l'ordre de quelques dizaines de nanomètres lorsque les portions 104 sont réalisées par photolithogravure ou par ablation laser. De manière générales, les dimensions minimales pouvant être atteintes dépendront de la ou des techniques mises en oeuvre pour réaliser la couche de semi-conducteur 102.

Les dimensions indiquées ci-dessus illustrent bien le fait que, étant donné que la réalisation du dispositif semi-conducteur 100 n'implique pas la mise en oeuvre d'étape d'alignement, il est possible d'augmenter la densité d'intégration des éléments électroniques réalisés à partir de la couche semi-conductrice 102. Ainsi, comme indiqué ci-dessus, la longueur de canal d'un des transistors peut être égale à environ 5 $\mu$m, ce qui bien inférieur à la longueur de canal des transistors généralement réalisés et qui nécessitent la mise en oeuvre d'étapes d'alignement. La longueur des électrodes $W_{SD}$, par exemple égale à environ 10 $\mu$m dans l'exemple donné ci-dessus, est également bien inférieure à longueur des électrodes des transistors nécessitant une étape d'alignement, généralement égale à environ 1 mm.

**Revendications**

1. Dispositif microélectronique (100) comportant :

   - une plurality de portions (104) de semi-conducteur disjointes de dimensions $L_{SC}$, $W_{SC}$ et de formes sensiblement similaires, isolées électriquement les unes des autres et formant une couche (102) de semi-conducteur, chacune des portions (104) de semi-conducteur étant espacée des portions (104) de semi-conducteur adjacentes d'une distance $E_{SCH}$, Escv sensiblement constante et comportant une forme allongée dont une plus grande dimension $L_{SC}$ est orientée sensiblement parallèlement aux plus grandes dimensions $L_{SC}$ des autres portions (104) de semi-conducteur,
   - au moins deux électrodes (108a, 108b, 108c, 108d) disposées en contact avec la couche (102) de semi-conducteur telles qu'une distance $L_{canal}$ maximale séparant les deux électrodes (108a, 108b, 108c, 108d) soit inférieure à une plus grande dimension $L_{SC}$ d'une des portions (104) de semi-conducteur,

   dans lequel la forme et les dimensions $L_{SC}$, $W_{SC}$ des portions (104) de semi-conducteur, l'espacement $E_{SCH}$, $E_{SCV}$ entre les portions (104) de semi-conduateur, la forme et les dimensions $L_{SD}$, $W_{SD}$ des électrodes (108a, 108b, 108c, 108d), ainsi que la disposition des électrodes (108a, 108b, 108c, 108d) par rapport aux portions (104) de semi-conducteur sont tels qu'au moins une des portions (104) de semi-conducteur relie électriquement les deux électrodes (108a, 108b, 108c, 108d) entre elles, les plus grandes dimensions $L_{SC}$ des portions (104) de semi-conducteur sont sensiblement perpendiculaires à une plus grande dimension $W_{SD}$ des électrodes (108a, 108b, 108c, 108d), les électrodes (108a, 108b, 108c, 108d) étant de formes et de dimensions $W_{SD}$, $L_{SD}$ sensiblement similaires, les portions (104) de semi-conducteur sont disposées, dans un plan parallèle à une face principale de la couche (102) de semi-conducteur au contact de laquelle sont disposées les électrodes (108a, 108b, 108c, 108d), conformément à un motif régulier de lignes parallèles,

des espaces $E_{SCH}$ entre les portions (104) de semi-conducteur d'une même ligne sont décalés, par rapport à des espaces entres les portions (104) de semi-conducteur d'une ligne adjacente et selon une direction parallèle aux lignes, d'une distance D égale à environ la plus grande dimension $L_{SC}$ des portions (104) de semi-conducteur divisée par n, avec n nombre réel compris entre 10 et 20,

et dans lequel la plus grande dimension $L_{SC}$ des portions (104) de semi-conducteur est sensiblement égale à n fois la distance $L_{canal}$ maximale séparant les deux électrodes (108a, 108b, 108c, 108d) et/ou dans lequel la plus grande dimension $W_{SD}$ des électrodes (108a, 108b, 108c, 108d) est supérieure à environ n fois la plus petite dimension $W_{SC}$ des portions (104) de semi-conducteur.

2. Dispositif (100) selon la revendication 1, dans lequel chacune des portions (104) de semi-conducteur comporte une forme sensiblement rectangulaire.

3. Dispositif (100) selon l'une des revendications précédentes, comportant au moins un transistor (106a, 106b) dont une zone active (114a, 114b) est formée par ladite au moins une des portions (104) de semi-conducteur reliant électriquement les deux électrodes (108a, 108b, 108c, 108d) entre elles, lesdites électrodes (108a, 108b, 108c, 108d) formant des électrodes de source et de drain du transistor (106a, 105b).

4. Dispositif (100) selon l'une des revendications précédentes, comportant une pluralité de transistors (106a, 106b), chaque transistor (106a, 106b) comportant :

   - au moins deux électrodes (108a, 108b, 108c, 108d) formant des électrodes de source et de drain disposées en contact avec la couche (102) de semi-conducteur telles qu'une distance $L_{canal}$ maximale séparant les deux électrodes (108a, 108b, 108c, 108d) d'un des transistors (106a, 106b) soit inférieure à environ la plus grande dimension $L_{SC}$ d'une des portions (104) de semi-conducteur,

   - une zone active (114a, 114b) formée par au moins une des portions (104) de semi-conducteur reliant électriquement les deux électrodes (108a, 108b, 108c, 108d) dudit transistor (106a, 106b) entre elles, et dans lequel,

   - les plus grandes dimensions $L_{SC}$ des portions (104) de semi-conducteur sont sensiblement perpendiculaires à une plus grande dimension $W_{SD}$ des électrodes (108a, 108b, 108c, 108d), les électrodes (108a, 108b, 108c, 108d) étant de formes et de dimensions $W_{SD}$, $L_{SD}$ sensiblement similaires,

   - une distance $E_{TR}$ séparant les électrodes (108b, 108c) de deux transistors (106a, 106b), selon une direction parallèle à la plus grande dimension $L_{SC}$ des portions (104) de semi-conducteur, pouvant être supérieure à environ la plus grande dimension $L_{SC}$ des portions (104) de semi-conducteur, et

   - les électrodes (108a, 108b, 108c, 108d) de deux transistors (106a, 106b) étant décalées, selon une direction sensiblement parallèle à la plus grande dimension $W_{SD}$ des électrodes (108a, 108b, 108c, 108d), d'une distance $E_{CO}$ supérieure à environ la plus petite dimension $W_{SC}$ des portions (104) de semi-conducteur.

5. Dispositif (100) selon l'une des revendications 3 ou 4, dans lequel le ou chaque transistor (106a, 106b), comporte en outre un diélectrique de grille (118a, 118b) et une grille (116a, 116b) disposés en regard de la zone active (114a, 114b) dudit transistor (106a, 106b).

6. Procédé de réalisation d'un dispositif microélectronique (100) comportant au moins les étapes de :

   - réalisation d'une pluralité de portions (104) de semi-conducteur disjointes de dimensions $L_{SC}$, $W_{SC}$ et de formes sensiblement similaires, isolées électriquement les unes des autres et formant une couche (102) de semi-conducteur, chacune des portions (104) de semi-conducteur étant espacée des portions (104) de semi-conducteur adjacentes d'une distance $E_{SCH}$, $E_{SCV}$ sensiblement constante et comporte une forme allongée dont une plus grande dimension $L_{SC}$ est orientée sensiblement parallèlement aux plus grandes dimensions $L_{SC}$ des autres portions (104) de semi-conducteur,

   - réalisation d'au moins deux électrodes (108a, 108b, 108c, 108d) disposées en contact avec la couche (102) de semi-conducteur telles qu'une distance $L_{canal}$ maximale séparant les deux électrodes (108a, 108b, 108c, 108d) soit inférieure à environ une plus grande dimension $L_{SC}$ d'une des portions (104) de semi-conducteur,

   dans lequel la forme et les dimensions $L_{SC}$, $W_{SC}$ des portions (104) de semi-conducteur, l'espacement $E_{SCH}$, $E_{scv}$ entre les portions (104) de semi-conducteur, la forme et les dimensions $L_{SD}$, $W_{SD}$ des électrodes (108a, 108b, 108c, 108d) ainsi que la disposition des électrodes (108a, 108b, 108c, 108d) par rapport aux portions (104) de semi-conducteur étant tels qu'au moins une des portions (104) de semi-conducteur relie électriquement les deux électrodes (108a, 108b, 108c, 108d) entre elles,

les plus grandes dimensions $L_{SC}$ des portions (104) de semi-conducteur sont sensiblement perpendiculaires à une plus grande dimension $W_{SD}$ des électrodes (108a, 108b, 108c, 108d), les électrodes (108a, 108b, 108e, 108d) étant de formes et de dimensions $W_{SD}$, $L_{SD}$ sensiblement similaires,

les portions (104) de semi-conducteur sont disposées, dans un plan parallèle à une face principale de la couche (102) de semi-conducteur au contact de laquelle sont disposées les électrodes (108a, 108b, 108c, 108d), conformément à un motif régulier de lignes parallèles,

des espaces $E_{SCH}$ entre les portions (104) de semi-conducteur d'une même ligne sont décalés, par rapport à des espaces entres les portions (104) de semi-conducteur d'une ligne adjacente et selon une direction parallèle aux lignes, d'une distance D égale à environ la plus grande dimension $L_{SC}$ des portions (104) de semi-conducteur divisée par n, avec n nombre réel compris entre 10 et 20,

et dans lequel la plus grande dimension $L_{SC}$ des portions (104) de semi-conducteur est sensiblement égale à n fois la distance $L_{canal}$ maximale séparant les deux électrodes (108a, 108b, 108c, 108d) et/ou dans lequel la plus grande dimension $W_{SD}$ des électrodes (108a, 108b, 108c, 108d) est supérieure à environ n fois la plus petite dimension $W_{SC}$ des portions (104) de semi-conducteur.

7. Procédé selon la revendication 6, dans lequel les portions (104) de semi-conducteur sont réalisées en mettant en oeuvre une étape de dépôt du semi-conducteur de type sérigraphie, impression par tampon ou héliographie, ou en mettant en oeuvre une étape de dépôt d'une couche dudit semi-conducteur puis une étape d'ablation par laser ou par photolithogravure ou par emboutissage de la couche de semi-conducteur.

8. Procédé selon l'une des revendications 6 ou 7, dans lequel les portions (104) de semi-conducteur sont tout d'abord réalisée sur un substrat (112), les électrodes (108a, 108b, 108c, 108d) étant ensuite réalisées sur les portions (104) de semi-conducteur, ou dans lequel les électrodes (108a, 108b, 108c, 108d) sont tout d'abord réalisées sur un substrat (112), les portions (104) de semi-conducteur étant ensuite réalisées sur les électrodes (108a, 108b, 108c, 108d).

**Patentansprüche**

1. Mikroelektronische Vorrichtung (100), umfassend:

- eine Vielzahl getrennter Halbleiter-Abschnitte (104) mit den Abmessungen Lsc, Wsc von im Wesentlichen ähnlicher bzw. vergleichbarer Form, die elektrisch voneinander isoliert sind und eine Halbleiterschicht (102) bilden, wobei jeder der Halbleiter-Abschnitte (104) zu den benachbarten Abschnitten im Wesentlichen konstante Abstände $E_{SCH}$ und Escv aufweist und von langgestreckter Form ist, wobei eine größere Abmessung $L_{SC}$ im Wesentlichen parallel zu den größeren Abmessungen Lsc der anderen Halbleiter-Abschnitte (104) ist,

- wenigstens zwei Elektroden (108a, 108b, 108c, 108d), so in Kontakt mit der Halbleiterschicht (102) angeordnet, dass ein maximaler die beiden Elektroden (108a, 108b, 108c, 108d) trennender Abstand $L_{canal}$ kleiner ist als eine größere Abmessung Lsc von einem der Halbleiter-Abschnitte (104),

bei der die Form und die Abmessungen Lsc, Wsc der Halbleiter-Abschnitte (104), die Abstände $E_{SCH}$ und Escv zwischen den Halbleiter-Abschnitten (104), die Form und die Abmessungen $L_{SD}$, $W_{SD}$ der Elektroden (108a, 108b, 108c, 108d) in Bezug auf die Halbleiter-Abschnitte (104) sowie die Anordnung der Elektroden (108a, 108b, 108c, 108d) in Bezug auf die Halbleiter-Abschnitte (104) so sind, dass wenigstens einer der Halbleiter-Abschnitte (104) die beiden Elektroden (108a, 108b, 108c, 108d) elektrisch miteinander verbindet,

wobei die größeren Abmessungen Lsc der Halbleiter-Abschnitte (104) im Wesentlichen senkrecht sind zu einer größeren Abmessung $W_{SD}$ der Elektroden (108a, 108b, 108c, 108d), und die Elektroden (108a, 108b, 108c, 108d) im Wesentlichen ähnliche bzw. vergleichbare Formen und Abmessungen $W_{SD}$, $L_{SD}$ aufweisen,

wobei die Halbleiter-Abschnitte (104) gemäß einem regelmäßigen Muster paralleler Linien bzw. Zeilen angeordnet sind in einer zu einer Hauptseite der Halbleiterschicht (102) parallelen Ebene, die Kontakt hat mit den Elektroden (108a, 108b, 108c, 108d), wobei Abstände $E_{SCH}$ zwischen den Halbleiter-Abschnitten (104) von ein und derselben Zeile in Bezug auf Abstände zwischen den Halbleiter-Abschnitten (104) und gemäß einer zu den Zeilen parallelen Richtung einer benachbarten Zeile versetzt sind um eine Distanz D gleich etwa der größeren bzw. größten Abmessung Lsc der Halbleiter-Abschnitte (104), geteilt durch n, mit n als reeller Zahl, enthalten zwischen 10 und 20,

und bei der die größere Abmessung Lsc der Halbleiter-Abschnitte (104) im Wesentlichen n-fach größer ist als der maximale Abstand $L_{canal}$, der die beiden Elektroden (108a, 108b, 108c, 108d) trennt, und/oder bei der die größere bzw. größte Abmessung $W_{SD}$ der Elektroden (108a, 108b, 108c, 108d) etwa n-fach größer ist als die kleinere bzw. kleinste Abmessung Wsc der Halbleiter-Abschnitte (104).

**2.** Vorrichtung (100) nach Anspruch 1, bei der jeder der Halbleiter-Abschnitte (104) eine im Wesentlichen rechteckige Form aufweist.

**3.** Vorrichtung (100) nach einem der vorhergehenden Ansprüche, wenigstens einen Transistor (106a, 106b) mit einer aktiven Zone (114a, 114b) umfassend, die gebildet wird durch den genannten wenigstens einen Halbleiter-Abschnitt (104), der die beiden Elektroden (108a, 108b, 108c, 108d) miteinander verbindet, wobei die beiden Elektroden (108a, 108b, 108c, 108d) Source- und Drainelektroden des Transistors (106a, 106b) bilden.

**4.** Vorrichtung nach einem der vorhergehenden Ansprüche mit einer Vielzahl Transistoren (106a, 106b), wobei jeder Transistor (106a, 106b) umfasst :

- wenigstens zwei Elektroden (108a, 108b, 108c, 108d), Source- und Drainelektroden bildend, angeordnet in Kontakt mit der Halbleiterschicht (102), so dass ein maximaler die beiden Elektroden (108a, 108b, 108c, 108d) von einem der Transistoren (106a, 106b) trennender Abstand $L_{canal}$ kleiner ist als etwa der größere bzw. größte Abstand Lsc von einem der Halbleiter-Abschnitte (104),

- eine aktive Zone (114a, 114b), gebildet durch wenigstens einen der die beiden Elektroden (108a, 108b, 108c, 108d) des genannten Transistors (106a, 106b) elektrisch miteinander verbindenden Halbleiter-Abschnitte (104),

und bei der :

- die größeren bzw. größten Abmessungen Lsc der Halbleiter-Abschnitte (104) im Wesentlichen senkrecht sind zu einer größeren Abmessung $W_{SD}$ der Elektroden (108a, 108b, 108c, 108d), wobei die Elektroden (108a, 108b, 108c, 108d) im Wesentlichen vergleichbare bzw. ähnliche Formen und Abmessungen $W_{SD}$, $L_{SD}$ aufweisen,

- ein die Elektroden (108b, 108c) der beiden Transistoren (106a, 106b) gemäß einer zu der größeren Abmessung Lsc der Halbleiter-Abschnitte (104) parallelen Richtung trennender Abstand $E_{TR}$ größer sein kann als etwa der größere bzw. größte Abstand Lsc der Halbleiter-Abschnitte (104), und

- die Elektroden (108a, 108b, 108c, 108d) der beiden Transistoren (106a, 106b) gemäß einer Richtung, die im Wesentlichen parallel ist zu der größten Abmessung $W_{SD}$ der Elektroden (108a, 108b, 108c, 108d), versetzt sind um einen Abstand Eco, der größer ist als etwa die kleinste Abmessung Wsc der Halbleiter-Abschnitte (104).

**5.** Vorrichtung (100) nach einem der Ansprüche 3 oder 4, bei der der oder jeder Transistor (106a, 106) außerdem ein Gate-Dielektrikum (118a, 118b) und ein Gate (116a, 116b) umfasst, angeordnet gegenüber der aktiven Zone (114a, 114b) des genannten Transistors (106a, 106b).

**6.** Verfahren zur Herstellung einer mikroelektronischen Vorrichtung (100), folgende Schritte umfassend :

- Herstellung einer Vielzahl von Halbleiter-Abschnitten (104) mit den Abmessungen Lsc, Wsc von im Wesentlichen ähnlicher bzw. vergleichbarer Form, die elektrisch voneinander isoliert sind und eine Halbleiterschicht (102) bilden, wobei jeder der Halbleiter-Abschnitte (104) zu den benachbarten Abschnitten im Wesentlichen konstante Abstände $E_{SCH}$ und Escv aufweist und von langgestreckter Form ist, wobei eine größere Abmessung $L_{SC}$ im Wesentlichen parallel zu den größeren Abmessungen Lsc der anderen Halbleiter-Abschnitte (104) ist,

- Herstellung von wenigstens zwei Elektroden (108a, 108b, 108c, 108d), so in Kontakt mit der Halbleiterschicht (102) angeordnet, dass ein maximaler die beiden Elektroden (108a, 108b, 108c, 108d) trennender Abstand $L_{canal}$ kleiner ist als eine größere Abmessung Lsc von einem der Halbleiter-Abschnitte (104),

bei dem die Form und die Abmessungen Lsc, Wsc der Halbleiter-Abschnitte (104), die Abstände $E_{SCH}$ und Escv zwischen den Halbleiter-Abschnitten (104), die Form und die Abmessungen $L_{SD}$, $W_{SD}$ der Elektroden (108a, 108b, 108c, 108d) in Bezug auf die Halbleiter-Abschnitte (104) sowie die Anordnung der Elektroden (108a, 108b, 108c, 108d) in Bezug auf die Halbleiter-Abschnitte (104) so sind, dass wenigstens einer der Halbleiter-Abschnitte (104) die beiden Elektroden (108a, 108b, 108c, 108d) elektrisch miteinander verbindet,

wobei die größeren Abmessungen Lsc der Halbleiter-Abschnitte (104) im Wesentlichen senkrecht sind zu einer größeren Abmessung $W_{SD}$ der Elektroden (108a, 108b, 108c, 108d), und die Elektroden (108a, 108b, 108c, 108d) im Wesentlichen ähnliche bzw. vergleichbare Formen und Abmessungen $W_{SD}$, $L_{SD}$ aufweisen,

wobei die Halbleiter-Abschnitte (104) gemäß einem regelmäßigen Muster paralleler Linien bzw. Zeilen angeordnet sind in einer zu einer Hauptseite der Halbleiterschicht (102) parallelen Ebene, die Kontakt hat mit den Elektroden (108a, 108b, 108c, 108d), wobei Abstände $E_{SCH}$ zwischen den Halbleiter-Abschnitten (104) von ein und derselben Zeile in Bezug auf Abstände zwischen den Halbleiter-Abschnitten (104) und gemäß einer zu den Zeilen parallelen Richtung einer benachbarten Zeile versetzt sind um eine Distanz D gleich etwa der größeren bzw. größten Abmessung Lsc der Halbleiter-Abschnitte (104), geteilt durch n, mit n als reeller Zahl, enthalten zwischen 10 und 20,

und bei dem die größere Abmessung Lsc der Halbleiter-Abschnitte (104) im Wesentlichen n-fach größer ist als der maximale Abstand $L_{canal}$, der die beiden Elektroden (108a, 108b, 108c, 108d) trennt, und/oder bei dem die größere bzw. größte Abmessung $W_{SD}$ der Elektroden (108a, 108b, 108c, 108d) etwa n-fach größer ist als die kleinere bzw. kleinste Abmessung Wsc der Halbleiter-Abschnitte (104).

7. Verfahren nach Anspruch 6, bei dem die Halbleiter-Abschnitte (104) in einem Aufbringungsschritt des Typs Siebdruck, Stempel- oder Lichtpausdruck realisiert werden, oder indem ein Schritt zum Aufbringen einer Schicht aus dem genannten Halbleiter durchgeführt wird und dann ein Abtragungsschritt durch Laser oder Fotolithogravur, oder durch Prägen der Halbleiterschicht.

8. Verfahren nach einem der Ansprüche 6 oder 7, bei dem zunächst die Halbleiter-Abschnitte (104) auf einem Substrat (112) realisiert werden und anschließend die Elektroden (108a, 108b, 108c, 108d) auf den Halbleiter-Abschnitten (104) realisiert werden, oder bei dem zunächst die Elektroden (108a, 108b, 108c, 108d) auf einem Substrat (112) realisiert werden, und anschließend die Halbleiter-Abschnitte (104) auf den Elektroden (108a, 108b, 108c, 108d) realisiert werden.

**Claims**

1. Microelectronic device (100) comprising:

   - a plurality of disconnected semiconducting portions (104) with approximately similar dimensions $L_{SC}$, $W_{SC}$ and similar shapes, electrically isolated from each other and forming a semiconductor layer (102), each of the semiconductor portions (104) being spaced from adjacent semiconductor portions (104) by an approximately constant distance $E_{SCH}$, Escv and having an elongated shape of which the largest dimension $L_{SC}$ is approximately parallel to the largest dimensions $L_{SC}$ of the other semiconductor portions (104),
   - at least two electrodes (108a, 108b, 108c, 108d) arranged in contact with the semiconductor layer (102) such that a maximum distance $L_{channel}$ separating the two electrodes (108a, 108b, 108c, 108d) is less than the largest dimension $L_{SC}$ of one of the semiconductor portions (104),

in which the shape and dimensions $L_{SC}$, Wsc of the semiconductor portions (104), the spacing $E_{SCH}$, $E_{SCV}$ between the semiconductor portions (104), the shape and dimensions $L_{SD}$, $W_{SD}$ of the electrodes (108a, 108b, 108c, 108d) and the layout of the electrodes (108a, 108b, 108c, 108d) relative to the semiconductor portions (104) are such that at least one of the semiconductor portions (104) electrically connects the two electrodes (108a, 108b, 108c, 108d) to each other,

the largest dimensions $L_{SC}$ of the semiconductor portions (104) are approximately perpendicular to the largest dimension $W_{SD}$ of the electrodes (108a, 108b, 108c, 108d), the electrodes (108a, 108b, 108c, 108d) having approximately similar shapes and dimensions $W_{SD}$, $L_{SD}$,

the semiconductor portions (104) are arranged in a plane parallel to a principal face of the semiconductor layer (102) in contact with which the electrodes (108a, 108b, 108c, 108d) are arranged, following a regular pattern of parallel lines,

spaces $E_{SCH}$ between the semiconductor portions (104) on a single line are offset relative to the spaces between the semiconductor portions (104) of an adjacent line and along a direction parallel to the lines, by a distance D equal to about the largest dimension $L_{SC}$ of the semiconductor portions (104) divided by n, where n is a real number between 10 and 20,

and in which the largest dimension $L_{SC}$ of the semiconductor portions (104) is approximately equal to n times the maximum distance $L_{channel}$ separating the two electrodes (108a, 108b, 108c, 108d) and/or the largest dimension $W_{SD}$ of the electrodes (108a, 108b, 108c, 108d) is greater than about n times the smallest dimension $W_{SC}$ of the semiconductor portions (104).

2. Device (100) according to claim 1, in which each of the semiconductor portions (104) has an approximately rectangular shape.

3. Device (100) according to one of the previous claims, comprising at least one transistor (106a, 106b) of which an active zone (114a, 114b) is formed by said at least one of the semiconductor portions (104) electrically connecting the two electrodes (108a, 108b, 108c, 108d) to each other, said electrodes (108a, 108b, 108c, 108d) forming source and drain electrodes of the transistor (106a, 106b).

4. Device (100) according to one of the previous claims, comprising a plurality of transistors (106a, 106b), each transistor (106a, 106b) comprising:

   - at least two electrodes (108a, 108b, 108c, 108d) forming source and drain electrodes arranged in contact with the semiconductor layer (102) such that the maximum distance $L_{channel}$ separating the two electrodes (108a, 108b, 108c, 108d) of one of the transistors (106a, 106b) is less than about the largest dimension $L_{SC}$ of one of the semiconductor portions (104),
- an active zone (114a, 114b) formed by at least one of the semiconductor portions (104) electrically connecting the two electrodes (108a, 108b, 108c, 108d) of said transistor (106a, 106b) together, and in which,
- the largest dimensions $L_{SC}$ of the semiconductor portions (104) are approximately perpendicular to the largest dimension $W_{SD}$ of the electrodes (108a, 108b, 108c, 108d), the electrodes (108a, 108b, 108c, 108d) having approximately similar shapes and dimensions $W_{SD}$, $L_{SD}$,
- a distance $E_{TR}$ separating the electrodes (108b, 108c) of two transistors (106a, 106b), along a direction parallel to the largest dimension $L_{SC}$ of the semiconductor portions (104), that may be greater than about the largest dimension $L_{SC}$ of the semiconductor portions (104), and
- the electrodes (108a, 108b, 108c, 108d) of two transistors (106a, 106b) being offset, along a direction approximately parallel to the largest dimension $W_{SD}$ of the electrodes (108a, 108b, 108c, 108d), by a distance $E_{CO}$ greater than about the smallest dimension $W_{SC}$ of the semiconductor portions (104).

5. Device (100) according to claim 3 or 4, in which the transistor or each transistor (106a, 106b) also comprises a gate dielectric (118a, 118b) and a gate (116a, 116b) arranged facing the active zone (114a, 114b) of said transistor (106a, 106b).

6. Method of making a microelectronic device (100) comprising at least the following steps:

- make a plurality of disconnected semiconductor portions (104) with approximately similar dimensions $L_{SC}$, $W_{SC}$ and shapes, electrically isolated from each other and forming a semiconductor layer (102), each semiconductor portion (104) being spaced from adjacent semiconductor portions (104) by an approximately constant distance $E_{SCH}$, $E_{SCV}$ and having an elongated shape of which the largest dimension $L_{SC}$ is approximately parallel to the largest dimensions $L_{SC}$ of the other semiconductor portions (104),
- make at least two electrodes (108a, 108b, 108c, 108d) arranged in contact with the semiconductor layer (102) such that a maximum distance $L_{channel}$ separating the two electrodes (108a, 108b, 108c, 108d) is less than approximately the largest dimension $L_{SC}$ of one of the semiconductor portions (104),

in which the shape and dimensions $L_{SC}$, Wsc of the semiconductor portions (104), the spacing $E_{SCH}$, $E_{SCV}$ between the semiconductor portions (104), the shape and dimensions $L_{SD}$, $W_{SD}$ of the electrodes (108a, 108b, 108c, 108d) and the layout of the electrodes (108a, 108b, 108c, 108d) relative to the semiconductor portions (104) being such that at least one of the semiconductor portions (104) electrically connects the two electrodes (108a, 108b, 108c, 108d) to each other,
the largest dimensions $L_{SC}$ of the semiconductor portions (104) are approximately perpendicular to a largest dimension $W_{SD}$ of the electrodes (108a, 108b, 108c, 108d), the electrodes (108a, 108b, 108c, 108d) having approximately similar shapes and dimensions $W_{SD}$, $L_{SD}$,
the semiconductor portions (104) are arranged in a plane parallel to a principal face of the semiconductor layer (102) in contact with which the electrodes (108a, 108b, 108c, 108d) are arranged, following a regular pattern of parallel lines,
spaces $E_{SCH}$ between the semiconductor portions (104) of a single line are offset relative to spaces between the semiconductor portions (104) of an adjacent line and along a direction parallel to the lines, by a distance D equal to about the largest dimension $L_{SC}$ of the semiconductor portions (104) divided by n, where n is a real number between 10 and 20,
and in which the largest dimension $L_{SC}$ of the semiconductor portions (104) is approximately equal to n times the maximum distance $L_{channel}$ separating the two electrodes (108a, 108b, 108c, 108d) and/or in which the largest dimension $W_{SD}$ of the electrodes (108a, 108b, 108c, 108d) is greater than about n times the smallest dimension $W_{SC}$ of the semiconductor portions (104).

7. Method according to claim 6, in which the semiconductor portions (104) are made using a semiconductor deposition step of screen printing, buffer printing or heliography type, or using a step to deposit a layer of said semiconductor followed by an ablation step by laser or by photolithography or by stamping of the semiconductor layer.

8. Method according to claim 6 or 7, in which semiconductor portions (104) are made firstly on a substrate (112), the electrodes (108a, 108b, 108c, 108d) then being made on the semiconductor portions (104), or in which the electrodes (108a, 108b, 108c, 108d) are made firstly on a substrate (112), and the semiconductor portions (104) are then made on the electrodes (108a, 108b, 108c, 108d).

FIG. 1

FIG. 2

**FIG. 3**

FIG. 4

FIG. 5

**EP 2 567 418 B1**

**Documents brevets cités dans la description**

- EP 1727219 A1